(19) Europäisches Patentamt / European Patent Office / Office européen des brevets

(11) **EP 1 505 403 B1**

(12) **EUROPÄISCHE PATENTSCHRIFT**

(45) Veröffentlichungstag und Bekanntmachung des Hinweises auf die Patenterteilung:
**14.02.2007 Patentblatt 2007/07**

(51) Int Cl.:
*G01R 31/36* *(2006.01)*

(21) Anmeldenummer: **04014627.6**

(22) Anmeldetag: **22.06.2004**

(54) **Verfahren zur Ermittlung einer auf den Ladezustand einer Speicherbatterie bezogenen Kenngrösse**

Method for determining a parameter related to the state of the charge of a storage battery

Procédé pour déterminer un paramètre lié à l'état de charge d'une batterie de stockage

(84) Benannte Vertragsstaaten:
**AT BE BG CH CY CZ DE DK EE ES FI FR GB GR HU IE IT LI LU MC NL PL PT RO SE SI SK TR**

(30) Priorität: **06.08.2003 DE 10335928**

(43) Veröffentlichungstag der Anmeldung:
**09.02.2005 Patentblatt 2005/06**

(73) Patentinhaber: **VB Autobatterie GmbH & Co. KGaA**
**30419 Hannover (DE)**

(72) Erfinder:
• **Koch, Ingo, Dipl.-Ing.**
**31789 Hameln (DE)**
• **Meissner, Eberhard, Dr.**
**31515 Wunstorf (DE)**

(74) Vertreter: **Gerstein, Hans Joachim et al**
**Gramm, Lins & Partner GbR**
**Theodor-Heuss-Strasse 1**
**38122 Braunschweig (DE)**

(56) Entgegenhaltungen:
EP-A- 1 120 663          EP-A- 1 308 738
DE-A- 10 103 848         DE-A- 10 246 383
US-A- 5 539 318          US-A- 5 650 712
US-A- 5 808 445

• PATENT ABSTRACTS OF JAPAN Bd. 1999, Nr. 09, 30. Juli 1999 (1999-07-30) & JP 11 103505 A (NISSAN MOTOR CO LTD), 13. April 1999 (1999-04-13)

**Beschreibung**

Die Erfindung betrifft ein Verfahren zur Ermittlung einer auf den Ladezustand einer Speicherbatterie bezogenen Säureschichtungs-Kenngröße für die Säureschichtung im Elektrolyt der Speicherbatterie.

Es besteht ein Bedarf, den Zustand einer elektrochemischen Speicherbatterie, wie beispielsweise den Ladezustand oder die Hochstrombelastbarkeit, aktuell zu bestimmen oder vorherzusagen.

Beispielsweise sind für die Fähigkeit einer Starterbatterie, ein Kraftfahrzeug mit einem Verbrennungsmotor zu starten, der Ladezustand und der Alterungszustand bzw. der sich abzeichnende Kapazitätsverfall der Batterie maßgeblich, da die durch die Starterbatterie entnehmbare Stromstärke bzw. deren Leistungsabgabe begrenzt wird. Von besonderer Bedeutung ist die Ermittlung des Ladezustandes oder der Startfähigkeit einer Starterbatterie in den Fällen, in denen beispielsweise intermittierender Motorbetrieb vorliegt, da dann in den Motorstillstandszeiten das Bordnetz des Fahrzeugs mit seinen Verbrauchern weiter betrieben wird, allerdings der Generator keinen Strom erzeugt. Die Überwachung des Ladezustands und der Startfähigkeit der Speicherbatterie muss in solchen Fällen gewährleisten, dass der Energieinhalt der Speicherbatterie stets ausreichend bleibt, um den Motor noch zu starten.

Zur Messung des Ladezustands von Speicherbatterien sind die verschiedensten Verfahren bekannt. So werden beispielsweise integrierende Messgeräte benutzt (Ah-Zähler), wobei der Ladestrom ggf. unter Bewertung mit einem festen Ladefaktor berücksichtigt wird. Da die nutzbare Kapazität einer Speicherbatterie stark von der Größe des Entladestroms und der Temperatur abhängig ist, kann auch mit solchen Verfahren keine zufriedenstellende Aussage über die der Batterie noch entnehmbare nutzbare Kapazität getroffen werden.

Aus der DE 22 42 510 C1 ist beispielsweise bekannt, bei einem Verfahren zur Messung des Ladezustandes den Ladestrom mit einem von der Temperatur und dem vom Ladezustand der Batterie selbst abhängigen Faktor zu bewerten.

In der DE 40 07 883 A1 ist ein Verfahren beschrieben, bei dem die Startfähigkeit einer Speicherbatterie durch Messung der Batterieklemmenspannung und der Batterietemperatur und Vergleich mit einer für den zu prüfenden Batterietyp geltenden Ladezustandskurvenschar ermittelt wird.

Der DE 195 43 874 A1 ist ein Berechnungsverfahren für die Entladungscharakteristik und Restkapazitätsmessung einer Speicherbatterie zu entnehmen, bei dem ebenfalls Strom, Spannung und Temperatur gemessen wird, wobei die Entladungscharakteristik durch eine mathematische Funktion mit gekrümmter Oberfläche angenähert wird.

In der DE 39 01 680 C1 ist ein Verfahren zur Überwachung der Kaltstartfähigkeit einer Starterbatterie beschrieben, bei dem die Starterbatterie zeitweise mit einem Widerstand belastet wird. Die am Widerstand abfallende Spannung wird gemessen und daraus im Vergleich mit Erfahrungswerten festgestellt, ob die Kaltstartfähigkeit der Starterbatterie noch ausreicht. Zur Belastung der Starterbatterie dient dabei der Anlassvorgang.

Weiterhin ist in der DE 43 39 568 A1 ein Verfahren zur Ermittlung des Ladezustandes einer Kraftfahrzeug-Starterbatterie zu entnehmen, bei dem Batteriestrom und Ruhespannung gemessen werden und aus diesen auf den Ladezustand geschlossen wird. Dabei wird zusätzlich auch die Batterietemperatur berücksichtigt. Die während verschiedener Zeiträume gemessenen Ladeströme werden miteinander verglichen und daraus eine Restkapazität ermittelt.

In der DE 198 47 648 A1 ist ein Verfahren zum Erlernen eines Zusammenhangs zwischen der Ruhespannung und dem Ladezustand einer Speicherbatterie zum Zweck der Abschätzung der Speicherfähigkeit beschrieben. Aus der Beziehung der Ruhespannungsdifferenz zur während der Belastungsphase umgesetzten Strommenge wird ein Maß für die Säurekapazität des Elektrolyts der Speicherbatterie ermittelt. Dabei wird ausgenutzt, dass die Ruhespannung bei dem in der für die Praxis relevanten höheren Ladezustandsbereichen annähernd linear mit dem Ladezustand ansteigt.

Das Problem bei der Ermittlung des Zustands einer elektrochemischen Speicherbatterie mit dem vorbekannten Verfahren ist, dass nicht alle relevanten Verschleißfaktoren berücksichtigt werden, insbesondere wenn eine Säureschichtung vorliegt.

Im Falle eines Bleiakkumulators besteht der Elektrolyt aus verdünnter Schwefelsäure, d. h. eine Lösung von $H_2SO_4$ in Wasser. Typischerweise handelt es sich im vollständig geladenen Zustand um eine ca. 4 bis 5 molare Lösung. Bei der Entladereaktion wird entsprechend der Reaktionsgleichung

$$\text{Positive Elektrode: } PbO_2 + H_2SO_4 + 2H^+ + 2e^- \rightarrow PbSO_4 + 2H_2O$$

$$\text{Negative Elektrode: } Pb + H_2SO_4 \rightarrow Pb + 2H^+ + 2e^-$$

Im Elektrolyten $H_2SO_4$ an beiden Elektroden verbraucht und zudem $H_2O$ einer positiven Elektrode gebildet. Dadurch sinkt bei der Entladung die Konzentration und die spezifische Dichte des Elektrolyten, während sie bei der umgekehrt ablaufenden Ladereaktion wieder ansteigt.

Hat bei der Ladereaktion die gebildete Schwefelsäure die Möglichkeit einer Konvektion im Schwerefeld der Erde, so hat sie die Neigung in Schlieren zum Boden des Zellgefäßes der Zellen des Bleiakkumulators zu sinken. Dadurch liegt dann im unteren Bereich des jeweiligen Zellgefäßes ein Elektrolyt mit höherer Konzentration vor, als im oberen Bereich des Zellgefäßes. Dieser Zustand wird im Falle des Bleiakkumulators als Säureschichtung bezeichnet.

Da sowohl die Lade- / Entladereaktion als auch die parasitären Reaktionen, wie z.B. Gasentwicklung, Korrosion etc. im Allgemeinen von der Elektrolytkonzentration beeinflusst werden, führt eine Säureschichtung zu einer Verungleichmäßigung des Zustandes der Zelle.

JP 11 103505 A offenbart ein Verfahren zur Bestimmung des Ladezustandes einer Batterie durch Integration eines Lade-/Entladestroms der Batterie und durch Bestimmung der Klemmenspannung der Batterie, wenn der Entlade-/ Ladestrom Null ist. Die offene Klemmenspannung bei einem Nullstrom wird zur Ermittlung eines zweiten Ladezustandswertes genutzt, der zur Korrektur der Stromintegration bestimmten ersten Ladezustandswertes herangezogen wird.

EP 1 308 738 A2 offenbart ein Verfahren zum Bestimmen des Ladezustandes von Akkumulatoren durch Integration der bei Ladung und Entladung fließenden Strommengen sowie durch Auswertung von Ruhespannungswerten. Die Zuverlässigkeit der aus der Messung der Ruhespannung und der Stromintegration bestimmten Ladezustandswerte wird bestimmt und zur Ermittlung des tatsächlichen Ladezustandes wird der zuverlässigste Ladezustandswert herangezogen.

EP 1 120 663 A2 beschreibt ebenfalls ein Verfahren zur Bestimmung des Ladezustandes von Akkumulatoren, bei dem Ladezustandswerte bezogen auf der Batterieruhespannung und durch Stromintegration ermittelt werden. Es werden die Änderungen der Ladezustände berechnet und zur Ermittlung einer Ladezustandsänderung die gewichteten Mittel der mit unterschiedlichen Methoden bestimmten Ladezustandsänderungen gebildet.

US 5,650,712 A1 beschreibt ein Verfahren zur Ermittlung des Ladezustands einer Batterie, bei dem eine Entladekapazität durch Integration des Batteriestroms bestimmt wird. Hieraus wird ein vom Batteriestrom abhängiger Ladezustand ermittelt. Bei dem wird Ladezustandswert aus Erfahrungswerten bestimmt. Die beiden Ladezustandswerte werden miteinander korreliert.

DE 10103848 A1 beschreibt ein Verfahren zur Ermittlung von Zahlenwerten für die Säureschichtung einer Batterie anhand von Mitteln der Fuzzi-Logik. Dabei wird unter anderem die Differenz des Ladezustands der Batterie zu zwei verschiedenen Zeitpunkten berücksichtigt. Der Ladezustand wird dabei über aufintegriere Stromwerte ermittelt.

Aufgabe der Erfindung ist es daher, ein verbessertes Verfahren zur Ermittlung einer auf den Ladezustand einer Speicherbatterie bezogenen Säureschichtungs-Kenngröße zu schaffen.

Die Aufgabe wird erfindungsgemäß gelöst durch die Schritte des Anspruchs 1. Vorteilhafte Ausführungsformen sind in den abhängigen Ansprüchen beschrieben.

Dem Verfahren liegt die überraschende Erkenntnis zu Grunde, dass verschiedene Verfahren zur Bestimmung des Ladezustandswertes unterschiedlich durch Verschleißfaktoren, insbesondere eine Säureschichtung, beeinflusst werden, so dass sich für verschiedene Verfahren unterschiedliche Ladezustandsänderungen ergeben. Die Verschleißfaktoren werden dann sämtlichst bei der Ermittlung eines verbesserten Ladezustandswertes berücksichtigt, wenn dieser in Abhängigkeit der beiden Ladezustandsänderungen ermittelt wird, die nach einem ersten und einem zweiten Verfahren bestimmt wurden.

Zur Ermittlung einer Säureschichtung im Elektrolyt wird die Abhängigkeit des Ladezustands einer Speicherbatterie von der Differenz zwischen der ersten auf die Spannung der Speicherbatterie bezogenen Ladezustandsänderung und der zweiten auf den Stromdurchsatz bezogenen Ladezustandsänderung ausgewertet, wobei beispielsweise auf das Vorliegen einer Säureschichtung geschlossen wird, wenn bei einer Netto-Entladung die erste Ladezustandsänderung größer als die zweite Ladezustandsänderung ist, oder wenn bei einer Netto-Ladung die erste Ladezustandsänderung kleiner als die zweite Ladezustandsänderung ist.

Bei dem Vorliegen einer Säureschichtung in der Speicherbatterie ist beim Spannungssignal der Speicherbatterie zur Bestimmung des Ladezustandes eine stärkere Verminderung des Ladezustands zu erkennen, als es sich aus der Ladungsbilanz ergibt, die als zweites Verfahren zur Ermittlung des Ladezustands herangezogen wird, sofern zwischen dem ersten und zweiten Betriebszeitpunkt eine Netto-Entladung erfolgt ist. Falls zwischen dem ersten und zweiten Betriebszeitpunkt eine Netto-Ladung vorliegt, wird bei der Ermittlung des Ladezustands anhand der Spannung der Speicherbatterie eine stärkere Zunahme des Ladezustands erkannt, als es sich aus der Ladungsbilanz ergibt.

Es wird daher die Spannung der Speicherbatterie und insbesondere die Ruhespannung zur Bestimmung der ersten Ladezustandswerte eingesetzt. Zur Bestimmung des zweiten Ladezustandswertes wird der Stromdurchsatz eingesetzt, wobei vorzugsweise der zwischen dem ersten Betriebszeitpunkt und dem zweiten Betriebszeitpunkt geflossene Strom als umgesetzte Ladungsmenge bilanziert wird.

Dabei ist es aus den oben erwähnten Gründen vorteilhaft, die auf den Ladezustand bezogene Kenngröße in Abhängigkeit davon zu ermitteln, ob in dem Zeitraum zwischen dem ersten Betriebszeitpunkt und dem zweiten Betriebszeitpunkt eine Netto-Entladung oder Netto-Ladung der Speicherbatterie erfolgt ist.

Aus den ersten und zweiten Ladezustandsänderungen kann dann ein verbesserter Säureschichtungs-Kennwert oder Ladezustandswert bestimmt werden, wobei der glaubwürdigste Einzelwert stärker gewichtet wird. So kann der Säureschichtungs-Kennwert oder Ladezustandswert beispielsweise in Abhängigkeit davon ermittelt werden, welcher absolute Wert der ersten Ladezustandsänderung und der zweiten Ladezustandsänderung größer ist.

Vorteilhaft ist es, bei einer Netto-Entladung im Zeitraum zwischen dem ersten Betriebszeitpunkt und dem zweiten Betriebszeitpunkt den zum zweiten Betriebszeitpunkt ermittelten auf den Stromdurchsatz der Speicherbatterie bezogenen Ladezustandswert übergewichtet zur Ermittlung der Säureschichtungs-Kenngröße oder des Ladezustands heranzuziehen, sofern die erste Ladezustandsänderung eine auf die Spannung bezogene Ladezustandsänderung ist.

Bei einer Entladung sind die auf den ersten und zweiten Parameter bezogenen ersten und zweiten Ladezustandsänderungen kleiner Null. Wenn der Rückgang der über die Spannung ermittelten ersten Ladezustandsänderung größer ist, als der Rückgang der auf den Stromdurchsatz bezogenen Ladezustandsänderung, kann auf das Vorliegen einer Säureschichtung zum ersten Betriebszeitpunkt und deren teilweisen Abbau bis zum zweiten Betriebszeitpunkt geschlossen werden. Für die Bestimmung eines verbesserten Ladezustandswertes wird dann der zum zweiten Betriebszeitpunkt ermittelte auf den Stromdurchsatz bezogene Ladezustandswert verstärkt herangezogen, da nach dem Ende der Entladung die Säureschichtung geringer ist und der Ladezustandswert zum zweiten Betriebszeitpunkt glaubwürdiger als der Ladezustand zum ersten Betriebszeitpunkt ist. Andernfalls wird für die Bestimmung eines verbesserten Ladezustandswertes zum zweiten Betriebszeitpunkt der auf den Stromdurchsatz bezogene erste Ladezustandswert zum zweiten Betriebszeitpunkt nicht verstärkt herangezogen, da gegen das Vorliegen einer Säureschichtung geschlossen wird.

Für den Fall einer Netto-Ladung zwischen dem ersten und zweiten Betriebszeitpunkt wird auf das Vorliegen einer Säureschichtung zum ersten Betriebszeitpunkt und deren teilweisen Abbau bis zum zweiten Betriebszeitpunkt geschlossen, sofern die Zunahme des auf die Spannung bezogenen ersten Ladezustands größer ist, als die Zunahme des auf den Stromdurchsatz bezogene Ladezustandes. Dann wird für die Bestimmung des verbesserten Ladezustandswertes zum zweiten Betriebszeitpunkt verstärkt der auf die Spannung bezogene erste Ladezustandswert zum zweiten Betriebszeitpunkt herangezogen, da nach dem Ende der Ladung die Säureschichtung geringer ist und damit der auf die Spannung bezogene erste Ladezustandswert zum zweiten Betriebszeitpunkt glaubwürdiger als der entsprechende Ladezustandswert zum ersten Betriebszeitpunkt ist.

Andernfalls wird gegen das Vorliegen einer Säureschichtung geschlossen und für die Bestimmung des verbesserten Ladezustandswertes zum zweiten Betriebszeitpunkt der auf die Spannung bezogene erste Ladezustandswert zum zweiten Betriebszeitpunkt nicht verstärkt herangezogen.

Es ist vorteilhaft zum Vergleich des Größenverhältnisses zwischen erster Ladezustandsänderung und zweiter Ladezustandsänderung die Differenz zwischen erster und zweiter Ladezustandsänderung mit einem festgelegten Schwellwert zu vergleichen, der nicht notwendigerweise Null sein muss. Es hat sich als vorteilhaft herausgestellt, wenn der Schwellwert im Bereich von 1 bis 10 % des maximal möglichen Ladezustandswertes liegt.

Weiterhin ist es vorteilhaft zur Bestimmung der auf den Ladungsdurchsatz bezogenen Ladezustandswerte nur Ladungsmengen und/oder Entladungsmengen zu berücksichtigen, die einen festgelegten Mindestwert überschreiten. Auch dieser festgelegte Mindestwert sollte vorzugsweise im Bereich von 1 bis 10 % des maximal möglichen Ladezustandswertes liegen

Später ermittelte Ladungszustandswerte und/oder Speicherfähigkeitswerte können durch die früher ermittelte Differenz zwischen erster und zweiter Ladezustandsänderung korrigiert werden, insbesondere durch Subtraktion der Differenz von späteren Ladezustandswerten oder Speicherfähigkeitswerten. Dabei ist es vorteilhaft, die Korrektur der später ermittelten Ladezustandswerte oder Subtraktion des. Produktes aus der Differenz der Nennkapazität von späteren Speicherfähigkeitwerte mit der jeweils größten Differenz einer Menge von Differenzen durchzuführen. Es kann aber auch eine Korrektur der später ermittelten Ladezustandswerte oder Speicherfähigkeitswerte durch eine Menge von Differenzen zwischen erster und zweiter Ladezustandsänderung, insbesondere durch Subtraktion der Summe aller ermittelten Differenzen von späteren Ladezustandswerten oder Subtraktion des Produktes aus der Differenz mit der Nennkapazität von späteren Speicherfähigkeitswerten durchgeführt werden. Damit wird ein Kalibrierwert geschaffen, durch den Verfälschungen auch in solchen Zuständen kompensiert werden, die sich nicht durch Beeinflussung der Klemmenspannung manifestieren, insbesondere Verfälschungen, die sich durch Säureschichtung ergeben und die während der folgenden Betriebszeit annähernd gleich sind.

Weiterhin hat sich als vorteilhaft herausgestellt, wenn die auf den Ladezustand bezogene Kenngröße in Abhängigkeit von ersten und zweiten Ladezustandsänderungen nur dann ermittelt wird, wenn in zwei unterschiedlichen Zeitintervallen mit jeweils einem ersten und zweiten Betriebszeitpunkt sowohl eine Netto-Ladung in einem Zeitintervall als auch eine Netto-Entladung in dem anderen Zeitintervall erfolgt ist. Es hat sich gezeigt, dass bei Vorliegen einer Säureschichtung die Kennlinie der ersten Ladezustandsänderung als Funktion der zweiten Ladezustandsänderung bei einer Netto-Entladung steiler verläuft, als bei einer Netto-Ladung. Daher kann auf das Vorliegen einer Säureschichtung geschlossen werden, wenn das Entlade-Verhältnis zwischen erster und zweiter Ladezustandsänderung in dem Zeitintervall, in dem die Netto-Entladung erfolgt ist, größer als das Lade-Verhältnis zwischen erster und zweiter Ladezustandsänderung in dem anderen Zeitintervall ist, in dem eine Netto-Ladung erfolgt ist.

Der Ladevorgang der Speicherbatterie kann nach Anwendung des oben beschriebenen Verfahrens in Abhängigkeit von der ermittelten Kenngröße des verbesserten Ladezustands und/oder der ersten und zweiten Ladezustandsänderungen gesteuert werden. Das Verfahren zur Ermittlung einer auf den Ladezustand bezogenen Kenngröße sowie die dabei erhaltenen Werte, insbesondere der verbesserte Ladezustandswert und/oder die ersten und zweiten Ladezustandsänderungen können dann mit anderen Verfahren zur Bestimmung oder Vorhersage des Zustands oder Verhaltens eines Energiespeichers verknüpft werden.

Die Erfindung wird nachfolgend anhand der beigefügten Zeichnungen näher erläutert. Es zeigen:

Figur 1 - Diagramm des Verlaufs der Ruhespannung einer Speicherbatterie in Abhängigkeit von der Säuredichte eines Bleiakkumulators mit sechs in Serie geschalteten Zellen;

Figur 2 - Diagramm des Verhältnisses zwischen der Änderung eines ersten Ladezustandswertes $SOC_1$ im Verhältnis zur Veränderung des zweiten Ladezustandswertes $SOC_2$ bei einer Entladung und ungefähr gleicher Veränderung;

Figur 3 - Diagramm mit einer stärken Veränderung des ersten Ladezustandswertes im Vergleich zur Veränderung des zweiten Ladezustandswertes bei einer Entladung;

Figur 4 - Diagramm der Veränderung eines ersten Ladezustandswertes im Vergleich zur Veränderung eines zweiten Ladezustandswertes bei einer Netto-Ladung und ungefähr gleicher Veränderung;

Figur 5 - Diagramm einer stärkeren Veränderung des ersten Ladezustandswertes im Vergleich zur Veränderung des zweiten Ladezustandswertes bei einer Netto-Ladung.

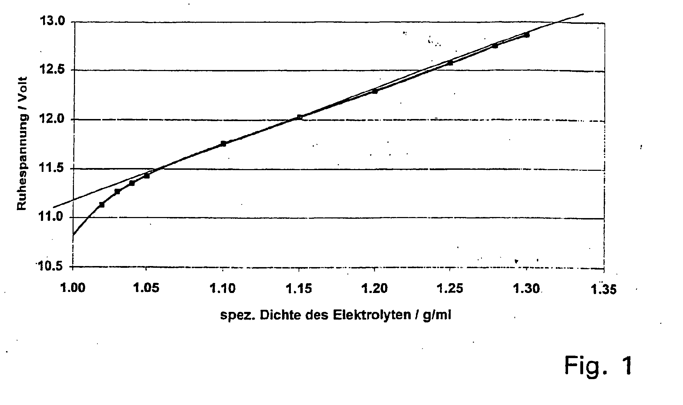

Die Ruhespannung eines Akkumulators hängt von der elektrochemischen Aktivität und damit von der Konzentration der beteiligten Komponenten ab. Im Falle des Bleiakkumulators steigt die Ruhespannung aufgrund elektrochemischer Zusammenhänge streng monoton mit der Säurekonzentration an, wie in der Figur 1 skizziert ist. Ist die Säurekonzentration, wie in dem dargestellten Beispiel inhomogen, so stellt sich an den Polen der Zelle ein Mischpotential ein, welches ein gewichtetes Mittel der an den verschiedenen Orten der Reaktion vorliegenden Potentiale darstellt. Beim Bleiakkumulator wird dieses Mischpotential vom Ort mit der höchsten Säurekonzentration dominiert, d. h. aus der Spannung am Pol kann auf die höchste Konzentration im elektrochemischen aktiven Bereich der Zelle rückgeschlossen werden.

Beispielsweise beträgt die Steigung pro Einzelzelle ca. $\dfrac{9,2\,\text{mV}}{0,01\,\text{g/ml}}$ und pro 12 Volt-Block eines Bleiakkumulators ca. $\dfrac{55\,\text{mV}}{0,01\,\text{g/ml}}$ .

Bei Akkumulatoren mit festgelegten Elektrolyten, sogenannten verschlossenen Akkumulatoren, bei denen der Elektrolyt z. B. in einem Glasfaservlies oder in einem Gel immobilisiert ist, wird die Konvektion des Elektrolyten dagegen unterbunden oder zumindest sehr stark vermindert, so dass diese vom hier behandelten Phänomen weniger stark oder gar nicht betroffen sind.

Für das erfindungsgemäße Verfahren zur Ermittlung des Ladezustandes einer Speicherbatterie wird nunmehr die Erkenntnis ausgenutzt, dass unterschiedliche Verfahren zur Bestimmung des Ladezustandes jeweils anders beeinflusst werden. Insbesondere werden Verfahren, die das Spannungssignal der Speicherbatterie zur Bestimmung des Ladezustandes nutzen, anders beeinflusst als Verfahren, welche den Ladungsdurchsatz bewerten.

Dabei hat sich überraschend gezeigt, dass die Abweichung unterschiedlich verläuft, je nachdem ob zwischen zwei Betriebszeitpunkten in der Summe eine Netto-Ladung oder eine Netto-Entladung stattgefunden hat. Sofern eine Netto-Entladung vorliegt, registrieren das Spannungssignal der Batterie zur Bestimmung eines darauf bezogenen ersten Ladezustandswertes $SOC_1$ eine stärkere Verminderung $\Delta SOC_1$ des Ladezustandswertes $SOC_1$, als es sich bei der Bestimmung des auf die Ladungsbilanz bezogenen zweiten Ladezustandswertes $SOC_2$ ergibt.

Liegt dagegen eine Netto-Ladung vor, registrieren das Spannungssignal der Speicherbatterie zur Bestimmung des darauf bezogenen ersten Ladezustandswertes $SOC_1$ eine weniger starke Zunahme $\Delta SOC_1$ des ersten Ladezustandswertes $SOC_1$. Diese ist unter Umständen schwächer als die Zunahme $\Delta SOC_2$.

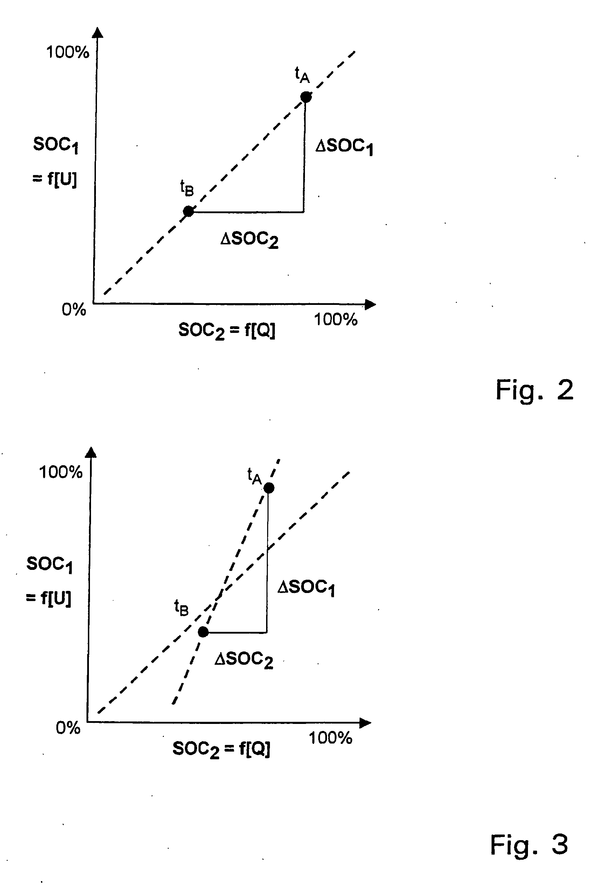

Unter Ausnutzung dieses unterschiedlichen Verhaltens kann nun ein verbesserter Ladezustandswert SOC bestimmt werden, der den glaubwürdigsten Einzelwert stärker wichtet. Dies wird anhand der Figuren 2 bis 5 detaillierter erläutert.

Die Figur 2 lässt ein Diagramm erkennen, bei dem ein erster insbesondere auf die Spannung der Speicherbatterie bezogener Ladezustandswert $SOC_1$ im Wertebereich von 0 bis 100% über einen zweiten Ladezustandsswertelauf $SOC_2$ aufgetragen ist, der insbesondere auf den Stromdurchsatz bezogen ist. Im Falle einer Entladung zwischen dem Zeitpunkt $t_A$ und dem Zeitpunkt $t_B$ ist eine Verminderung des ersten Ladungszustands $\Delta SOC_1$ in der Größenordnung

der Verminderung des zweiten Ladezustands $\Delta SOC_2$ zu beobachten. Betragsmäßig sind die Veränderungen somit vergleichbar. Dann erfolgt keine bevorzugte Wichtung der ersten und zweiten Ladezustandswerte $SOC_1$, $SOC_2$ zum ersten und/oder zweiten Betriebszeitpunkt $t_A$, $t_B$ zur Ermittlung des Ladezustandes SOC.

Die Figur 3 lässt hingegen den Fall der Netto-Entladung erkennen, bei dem die Veränderung des ersten Ladezustandswertes $\Delta SOC_1$ betragsmäßig größer als die Veränderung des zweiten Ladezustandswertes $\Delta SOC_2$ zwischen dem ersten und zweiten Betriebszeitpunkt $t_A$ und $t_B$ ist. Der Kurvenverlauf des über den zweiten Ladezustandswert $SOC_2$ aufgetragenen ersten Ladezustandswertes $SOC_1$ ist entsprechend beispielsweise aufgrund einer Säureschichtung steiler. In diesem Falle wird der Ladezustand SOC der Speicherbatterie bevorzugt durch übermäßige Wichtung des zweiten Ladezustandswertes $SOC_2$ insbesondere zum zweiten Betriebszeitpunkt $t_B$ bestimmt.

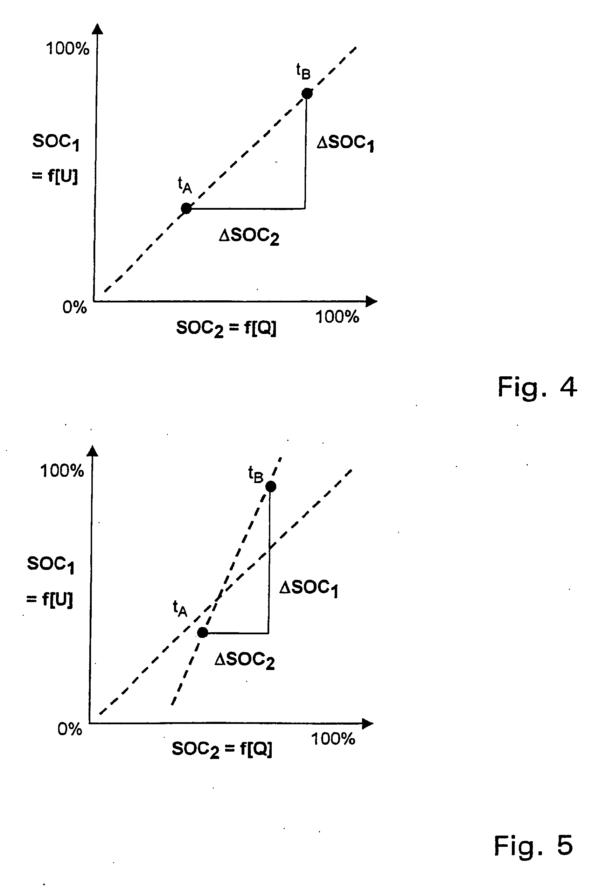

Die Figur 4 lässt den Fall der Netto-Ladung erkennen, wenn die Zunahme des ersten Ladezustandswertes $\Delta SOC_1$ betragsmäßig in der Größenordnung der Zunahme des zweiten Ladezustandswertes $\Delta SOC_2$ zwischen dem ersten Betriebszeitpunkt $t_A$ und dem zweiten Betriebszeitpunkt $t_B$ ist. Dann erfolgt wiederum keine bevorzugte Berücksichtigung des ersten oder zweiten Ladezustandsswertes $SOC_1$ und $SOC_2$ zur Ermittlung des Ladezustandes SOC.

Hingegen wird, wie in der Figur 5 für den Fall der Netto-Ladung skizziert ist, der erste Ladezustandswert $SOC_1$ zum zweiten Betriebszeitpunkt $t_B$ verstärkt zur Ermittlung des Ladezustandes SOC herangezogen, wenn die Veränderung des ersten Ladezustandswertes $\Delta SOC_1$ betragsmäßig größer als die Veränderung des zweiten Ladezustandswertes $\Delta SOC_2$ ist.

Es kann auch ein Kapazitätsverlustwert $Q_S$ bestimmt werden, der von allen zukünftig bestimmten Ladezustandswerten SOC abgezogen wird, um eine Verfälschung auch in solchen Zuständen zu berücksichtigen, in denen sie sich nicht durch Beeinflussung der Klemmenspannung manifestiert.

Der zur Ermittlung eines verbesserten Ladezustandwertes SOC genutzte Effekt kann am Beispiel der Säureschichtung wie folgt erklärt werden.

Bei einer eingetretenen Säureschichtung ist die erhöhte Säuredichte im unteren Bereich der Speicherbatterie bestimmend für die Klemmenspannung. Dabei erfolgt eine Entladung bevorzugt unten im Bereich der hohen Säuredichte. Hierdurch vermindert eine Entladung mit einem Ladungsumsatz $\Delta Q$ die lokale Säuredichte vorwiegend im unteren Bereich und damit die Ruhespannung $U_0$ relativ stärker, als wenn die Entladung homogen über der Bauhöhe der Speicherbatterie verlaufen würde.

Die Diskrepanz zwischen der vergleichsweisen starken Änderung der gemessenen Klemmenspannung bei einem gegebenen Ladungsumsatz $\Delta Q$ bei einer Entladung wird dabei ausgenutzt.

Bei Vorliegen einer Säureschichtung erfolgt eine Ladung bevorzugt in der Mitte und im oberen Bereich der Speicherbatterie, in dem eine geringere Säuredichte vorliegt. Dadurch erhöht eine Ladung mit einem Ladungsumsatz $\Delta Q$ dort die lokale Säuredichte stärker, als wenn die Entladung homogen über der Bauhöhe verlaufen würde. Da die Säuredichte in der Mitte und im oberen Bereich jedoch nicht die Ruhespannung bestimmen, ist diese trotz Ladung unverändert. Zumindest ist die Änderung betragsmäßig kleiner als es bei einer Entladung beobachtet wird.

Die Diskrepanz zwischen der vergleichsweise geringen Änderung der gemessenen Klemmenspannung bei gegebenen Ladungsumsatz $\Delta Q$ einer Ladung wird dabei ausgenutzt.

**Patentansprüche**

1.  Verfahren zur Ermittlung einer auf den Ladezustand (SOC) einer Speicherbatterie bezogenen Säureschichtungs-Kenngröße für die Säureschichtung im Elektrolyt der Speicherbatterie mit den Schritten:

    - Bestimmen eines auf die Spannung der Speicherbatterie bezogenen ersten Ladezustandswertes ($SOC_1$) jeweils für einen ersten Betriebszeitpunkt ($t_A$) und einen zweiten Betriebszeitpunkt ($t_B$);
    - Bestimmen eines auf den Stromdurchsatz der Speicherbatterie bezogenen zweiten Ladezustandswertes ($SOC_2$) jeweils für einen ersten Betriebszeitpunkt ($t_A$) und einen zweiten Betriebszeitpunkt ($t_B$);
    - Bestimmen einer ersten Ladezustandsänderung ($\Delta SOC_1$) des ersten Ladezustandswertes ($SOC_1$) von dem ersten zum zweiten Betriebszeitpunkt ($t_A$, $t_B$);
    - Bestimmen einer zweiten Ladezustandsänderung ($\Delta SOC_2$) des zweiten Ladezustandswertes ($SOC_2$) von dem ersten zum zweiten Betriebszeitpunkt ($t_A$, $t_B$);

    **gekennzeichnet durch**

    - Ermitteln der Differenz ($\Delta\Delta SOC$) zwischen der ersten Ladezustandsänderung ($\Delta SOC_1$) und der zweiten Ladezustandsänderung ($\Delta SOC_2$) und
    - Bestimmen der Säureschichtungs-Kenngröße in Abhängigkeit von der ermittelten Differenz.

2. Verfahren nach Anspruch 1, **dadurch gekennzeichnet, dass** der erste Ladezustandswert ($SOC_1$) auf die Ruhespannung ($U_{00}$) der Speicherbatterie bezogen ist.

3. Verfahren nach Anspruch 1 oder 2, **gekennzeichnet durch** Bestimmen des zweiten Ladezustandswertes ($SOC_2$) **durch** Bilanzieren des zwischen dem ersten Betriebszeitpunkt ($t_A$) und dem zweiten Betriebszeitpunkt ($t_B$) geflossenen Stromes als umgesetzte Ladungsmenge ($\Delta Q$).

4. Verfahren nach einem der vorhergehenden Ansprüche, **dadurch gekennzeichnet, dass** die auf den Ladezustand (SOC) bezogene Säureschichtungs-Kenngröße weiterhin in Abhängigkeit davon ermittelt wird, ob in dem Zeitraum zwischen dem ersten Betriebszeitpunkt ($t_A$) und dem zweiten Betriebszeitpunkt ($t_B$)eine Netto-Entladung oder Netto-Ladung der Speicherbatterie erfolgt ist.

5. Verfahren nach einem der vorhergehenden Ansprüche, **dadurch gekennzeichnet, dass** die auf den Ladezustand (SOC) bezogene Säureschichtungs-Kenngröße in Abhängigkeit davon ermittelt wird, welche absolute Wert der ersten Ladezustandsänderung ($\Delta SOC_1$) und der zweiten Ladezustandsänderung ($\Delta SOC_2$) größer ist.

6. Verfahren nach einem der vorhergehenden Ansprüche, **dadurch gekennzeichnet, dass** bei einer Netto-Entladung im Zeitraum zwischen dem ersten Betriebszeitpunkt ($t_A$) und dem zweiten Betriebszeitpunkt ($t_B$) der zum zweiten Betriebszeitpunkt ($t_B$) ermittelte auf den Stromdurchsatz der Speicherbatterie bezogene zweite Ladezustandswert ($SOC_2$) übergewichtet zur Ermittlung der auf den Ladezustand (SOC) bezogenen Säureschichtungs-Kenngröße herangezogen wird, wenn die erste Ladezustandsänderung ($\Delta SOC_1$) betragsmäßig kleiner als eine auf den Stromdurchsatz bezogene zweite Ladezustandsänderung ($\Delta SOC_2$) ist.

7. Verfahren nach einem der vorhergehenden Ansprüche, **dadurch gekennzeichnet, dass** bei einer Netto-Ladung im Zeitraum zwischen dem ersten Betriebszeitpunkt ($t_A$) und dem zweiten Betriebszeitpunkt ($t_B$) der zum zweiten Betriebszeitpunkt ($t_B$) ermittelte auf die Spannung der Speicherbatterie bezogene erste Ladezustandswert ($SOC_1$) übergewichtet zur Ermittlung der auf den Ladezustand (SOC) bezogenen Säureschichtungs-Kenngröße herangezogen wird, wenn die erste Ladezustandsänderung ($\Delta SOC_1$) betragsmäßig kleiner als eine auf den Stromdurchsatz bezogene zweite Ladezustandsänderung ($\Delta SOC_2$) ist.

8. Verfahren nach Anspruch 7, **dadurch gekennzeichnet, dass** eine Säureschichtung angenommen wird, wenn bei einer Netto-Entladung die erste Ladezustandsänderung ($\Delta SOC_1$) größer als die zweite Ladezustandsänderung ($\Delta SOC_2$) ist.

9. Verfahren nach einem der vorhergehenden Ansprüche, **dadurch gekennzeichnet, dass** eine Säureschichtung angenommen wird, wenn bei einer Netto-Ladung die erste Ladezustandsänderung ($\Delta SOC_1$) kleiner als die zweite Ladezustandsänderung ($\Delta SOC_2$) ist.

10. Verfahren nach einem der Ansprüche 5 bis 9, **dadurch gekennzeichnet, dass** zum Vergleich des Größenverhältnisses zwischen erster Ladezustandsänderung ($\Delta SOC_1$) und zweiter Ladezustandsänderung ($\Delta SOC_2$) die Differenz ($\Delta\Delta SOC$) zwischen erster und zweiter Ladezustandsänderung ($\Delta SOC_1$-$\Delta SOC_2$) mit einem festgelegten Schwellwert verglichen wird.

11. Verfahren nach Anspruch 10, **dadurch gekennzeichnet, dass** der Schwellwert im Bereich von 1 bis 10 % des maximal möglichen Ladezustandswertes (SOC) liegt.

12. Verfahren nach einem der vorhergehenden Ansprüche, **dadurch gekennzeichnet, dass** zur Bestimmung der auf den Ladungsdurchsatz ($\Delta Q$) bezogenen Ladezustandswerte ($SOC_2$) nur Ladungsmengen und/oder Entladungsmengen berücksichtigt werden, die einen festgelegten Mindestwert überschreiten.

13. Verfahren nach Anspruch 12, **dadurch gekennzeichnet, dass** der festgelegte Mindestwert im Bereich von 1 bis 10 % des maximal möglichen Ladezustandswertes (SOC) liegt.

14. Verfahren nach einem der vorhergehenden Ansprüche, **gekennzeichnet durch** Korrektur von später ermittelten Ladezustandswerten (SOC) oder Speicherfähigkeitswerten (Q) **durch** die früher ermittelte Differenz ($\Delta\Delta SOC$) zwischen erster und zweiter Ladezustandsänderung ($\Delta SOC_1$-$\Delta SOC_2$), insbesondere **durch** Subtraktion der Differenz ($\Delta\Delta SOC$) von späteren Ladezustandswerten (SOC) oder **durch** Subtraktion des Produktes der Differenz ($\Delta\Delta SOC$) mit der Nennkapazität der Speicherbatterie von späteren Speicherfähigkeitswerten (Q).

**15.** Verfahren nach Anspruch 14, **gekennzeichnet durch** Korrektur der später ermittelten Ladezustandswerte (SOC) oder Speicherfähigkeitswerte (Q) mit der jeweils größten Differenz ($\Delta\Delta SOC_{max}$) einer Menge von Differenzen ($\Delta\Delta$ SOC).

**16.** Verfahren nach Anspruch 14, **gekennzeichnet durch** Korrektur der später ermittelten Ladezustandswerte (SOC) oder Speicherfähigkeitswerte (Q) **durch** eine Menge von Differenzen ($\Delta\Delta SOC$) zwischen erster und zweiter Lade-zustandsänderung ($\Delta SOC_1$-$\Delta SOC_2$), insbesondere **durch** Subtraktion der Summe aller ermittelten Differenzen ($\Delta\Delta$ SOC) von späteren Ladezustandswerten (SOC) oder **durch** Subtraktion des Produktes der Differenz ($\Delta\Delta SOC$) mit der Nennkapazität der Speicherbatterie von späteren Speicherfähigkeitswerten (Q)

**17.** Verfahren nach einem der vorhergehenden Ansprüche, **gekennzeichnet durch** Ermitteln der auf den Ladezustand (SOC) bezogenen Säureschichtungs-Kenngröße in Abhängigkeit von ersten und zweiten Ladezustandsänderungen ($\Delta SOC_1$, $\Delta SOC_2$) nur dann, wenn in zwei unterschiedlichen Zeitintervallen ($\Delta_{t1}$, $\Delta_{t2}$) mit jeweils einem ersten und zweiten Betriebszeitpunkt ($t_A$, $t_B$) eine Netto-Entladung und eine Netto-Ladung erfolgt ist, wobei eine Säureschichtung angenommen wird, wenn das Entlade-Verhältnis (E = $|\Delta SOC_1'|$ : $|\Delta SOC_2'|$) zwischen der ersten und zweiten Ladezustandsänderung ($\Delta SOC_1$ $\Delta SOC_2$) in dem Zeitintervall ($\Delta_{t1}$), in dem eine Netto-Entladung erfolgt ist, größer als das Lade-Verhältnis (VL = $|\Delta SOC_1''|$ : $|\Delta SOC_2''|$) zwischen der ersten und zweiten Ladezustandsänderung ($\Delta_{t2}$) ist, in dem eine Netto-Ladung erfolgt ist.

**18.** Verfahren nach Anspruch 17, **dadurch gekennzeichnet, dass** zwischen den zwei unterschiedlichen Zeitintervallen ($\Delta t_1$, $\Delta t_2$) kein Ladungsdurchsatz erfolgt ist.

**19.** Verfahren nach einem der vorhergehenden Ansprüche, **gekennzeichnet durch** Steuerung des Ladungsablaufs der Speicherbatterie in Abhängigkeit von der ermittelten auf den Ladezustand (SOC) bezogenen Säureschichtungs-Kenngröße und/oder den ersten und zweiten Ladezustandsänderungen ($\Delta SOC_1$, $\Delta SOC_2$).

**20.** Verfahren nach einem der vorhergehenden Ansprüche, **dadurch gekennzeichnet, dass** die Speicherbatterie ein Bleiakkumulator ist.

**Claims**

**1.** Method for determination of an acid stratification characteristic variable which relates to the state of charge (SOC) of a storage battery, for the acid stratification in the electrolyte of the storage battery, having the following steps:

- determination of a first state of charge value ($SOC_1$) which relates to the voltage of the storage battery, in each case for a first operating time ($t_A$) and a second operating time ($t_B$);
- determination of a second state of charge value ($SOC_2$), which relates to the current throughput of the storage battery, in each case for a first operating time ($t_A$) and a second operating time ($t_B$) ;
- determination of a first state of charge change ($\Delta SOC_1$) of the first state of charge value ($SOC_1$) from the first to the second operating time ($t_A$, $t_B$);
- determination of a second state of charge change ($\Delta SOC_2$) of the second state of charge value ($SOC_2$) from the first to the second operating time ($t_A$, $t_B$);

**characterized by**

- determination of the difference ($\Delta\Delta SOC$) between the first state of charge change ($\Delta SOC_1$) and the second state of charge change ($\Delta SOC_2$), and
- determination of the acid-stratification characteristic variable as a function of the determined difference.

**2.** Method according to Claim 1, **characterized in that** the first state of charge value ($SOC_1$) relates to the rest voltage ($U_{00}$) of the storage battery.

**3.** Method according to Claim 1 or 2, **characterized by** determination of the second state of charge value ($SOC_2$) by balancing the current which flows between the first operating time ($t_A$) and the second operating time ($t_B$) as the amount of charge ($\Delta Q$) transferred.

**4.** Method according to one of the preceding claims, **characterized in that** the acid stratification characteristic variable which relates to the state of charge (SOC) is also determined as a function of whether a net discharge from or a net charge to the storage battery takes place in the time period between the first operating time ($t_A$) and the second operating time ($t_B$).

5. Method according to one of the preceding claims, **characterized in that** the acid stratification characteristic variable which relates to the state of charge (SOC) is determined as a function of which absolute value of the first state of charge change ($\Delta SOC_1$) and of the second state of charge change ($\Delta SOC_2$) is the greater.

6. Method according to one of the preceding claims, **characterized in that**, if there is a net discharge in the time period between the first operating time ($t_A$) and the second operating time ($t_B$), the second state of charge value ($SOC_2$), which was determined at the second operating time ($t_B$) and relates to the current throughput of the storage battery, is used in an emphasized form in order to determine the acid stratification characteristic variable which relates to the state of charge (SOC), if the magnitude of the first state of charge change ($\Delta SOC_1$) is less than that of a second state of charge change ($\Delta SOC_2$) which relates to the current throughput.

7. Method according to one of the preceding claims, **characterized in that**, if there is a net charge in the time period between the first operating time ($t_A$) and the second operating time ($t_B$), the first state of charge value ($SOC_1$), which was determined at the second operating time ($t_B$) and relates to the voltage of the storage battery, is used in an emphasized form in order to determine the acid stratification characteristic variable which relates to the state of charge (SOC), if the magnitude of the first state of charge change ($\Delta SOC_1$) is less than that of a second state of charge change ($\Delta SOC_2$) which relates to the current throughput.

8. Method according to Claim 7, **characterized in that** acid stratification is assumed when, in the case of a net discharge, the first state of charge change ($\Delta SOC_1$) is greater than the second state of charge change ($ASOC_2$)

9. Method according to one of the preceding claims, **characterized in that** acid stratification is assumed when, in the case of a net charge, the first state of charge change ($\Delta SOC_1$) is less than the second state of charge change ($\Delta SOC_2$).

10. Method according to one of Claims 5 to 9, **characterized in that** the difference ($\Delta\Delta SOC$) between the first and the second state of charge change ($\Delta SOC_1$-$\Delta SOC_2$) is compared with a fixed threshold value in order to compare the ratio of the magnitudes between the first state of charge change ($\Delta SOC_1$) and the second state of charge change ($\Delta SOC_2$).

11. Method according to Claim 10, **characterized in that** the threshold value is in the range from 1 to 10% of the maximum possible state of charge value (SOC).

12. Method according to one of the preceding claims, **characterized in that** only charge amounts and/or discharge amounts which exceed a fixed minimum value are taken into account for determination of the state of charge values ($SOC_2$) which relate to the charge throughput (AQ).

13. Method according to Claim 12, **characterized in that** the fixed minimum value is in the range from 1 to 10% of the maximum possible state of charge value (SOC).

14. Method according to one of the preceding claims, **characterized by** correction of state of charge values (SOC) or of storage capability values (Q) which are determined later by means of the difference ($\Delta\Delta SOC$), as determined earlier, between the first and the second state of charge change ($\Delta SOC_1$-$\Delta SOC_2$) in particular by subtraction of the difference ($\Delta\Delta SOC$) of later state of charge values (SOC) or by subtraction of the product of the difference ($\Delta\Delta SOC$) times the rated capacity of the storage battery from later storage capability values (Q).

15. Method according to Claim 14, **characterized by** correction of the state of charge values (SOC) or storage capability values (Q) determined later by means of the respective greatest difference ($\Delta\Delta SOC_{max}$) of a set of differences ($\Delta\Delta SOC$).

16. Method according to Claim 14, **characterized by** correction of the state of charge values (SOC) or storage capability values (Q) determined later by means of a set of differences ($\Delta\Delta SOC$) between the first and the second state of charge change ($\Delta SOC_1$-$\Delta SOC_2$), in particular by subtraction of the sum of all the determined differences ($\Delta\Delta SOC$) from later state of charge values (SOC), or by subtraction of the product of the difference ($\Delta\Delta SOC$) times the rated capacity of the storage battery from later storage capability values (Q).

17. Method according to one of the preceding claims, **characterized by** determination of the acid stratification characteristic variable which relates to the state of charge (SOC) as a function of first and second state of charge changes ($\Delta SOC_1$, $\Delta SOC_2$) only when a net discharge and a net charge take place in two different time intervals ($\Delta t_1$, $\Delta t_2$) which each have a first and a second operating time ($t_A$, $t_B$), with acid stratification being assumed when the discharge ratio (E= $|\Delta SOC_1'|$ : $|\Delta SOC_2'|$) between the first and the second state of charge change ($\Delta SOC_1'$, $\Delta SOC_2'$) in the time interval ($\Delta t_1$) in which a net discharge has taken place is greater than the charge ratio (VL=$|\Delta SOC_1''|$ : $|\Delta SOC_2''|$) between the first and the second state of charge change ($\Delta t_2$) in which a net charge has taken place.

18. Method according to Claim 17, **characterized in that** no charge throughput takes place between the two different time intervals ($\Delta t_1$, $\Delta t_2$).

19. Method according to one of the preceding claims, **characterized by** control of the charging procedure for the storage battery as a function of the acid stratification characteristic variable which has been determined and relates to the state of charge (SOC), and/or as a function of the first and the second state of charge changes ($\Delta SOC_1$, $\Delta SOC_2$).

20. Method according to one of the preceding claims, **characterized in that** the storage battery is a lead-acid rechargeable battery.


**Revendications**

1. Procédé de détermination d'un paramètre de stratification d'acide, lié à l'état de charge (SOC) d'une batterie d'accumulateur, pour la stratification d'acide dans l'électrolyte de la batterie d'accumulateur, comportant les étapes suivantes :

   - détermination d'une première valeur d'état de charge ($SOC_1$) liée à la tension de la batterie d'accumulateur, respectivement à un premier instant de fonctionnement ($t_A$) et à un second instant de fonctionnement ($t_B$);
   - détermination d'une seconde valeur d'état de charge ($SOC_2$) liée au débit de courant de la batterie d'accumulateur, respectivement à un premier instant de fonctionnement ($t_A$) et à un second instant de fonctionnement ($t_B$) ;
   - détermination d'une première variation d'état de charge ($\Delta SOC_1$) de la première valeur d'état de charge ($SOC_1$) en passant du premier au second instant de fonctionnement ($t_A$, $t_B$) ;
   - détermination d'une seconde variation d'état de charge ($\Delta SOC_2$) de la seconde valeur d'état de charge ($SOC_2$) en passant du premier au second instant de fonctionnement ($t_A$, $t_B$),

   **caractérisé par**

   - la détermination de la différence ($\Delta\Delta SOC$) entre la première variation d'état de charge ($\Delta SOC_1$) et la seconde variation d'état de charge ($\Delta SOC_2$) ; et
   - la détermination du paramètre de stratification d'acide en fonction de la différence déterminée.

2. Procédé selon la revendication 1,
   **caractérisé en ce que**
   la première valeur d'état de charge ($SOC_1$) est liée à la tension de repos ($U_{00}$) de la batterie d'accumulateur.

3. Procédé selon la revendication 1 ou 2,
   **caractérisé par**
   la détermination de la seconde valeur d'état de charge ($SOC_2$) par l'établissement d'un bilan du courant écoulé entre le premier instant de fonctionnement ($t_A$) et le second instant de fonctionnement ($t_B$); comme quantité de charge convertie ($\Delta Q$).

4. Procédé selon l'une quelconque des revendications précédentes,
   **caractérisé en ce que**
   le paramètre de stratification d'acide lié à l'état de charge (SOC) est déterminé par ailleurs en fonction du fait de savoir si, dans l'intervalle de temps compris entre le premier instant de fonctionnement ($t_A$) et le second instant de fonctionnement ($t_B$), une décharge nette ou une charge nette de la batterie d'accumulateur s'est effectuée.

5. Procédé selon l'une quelconque des revendications précédentes,

**caractérisé en ce que**
le paramètre de stratification d'acide lié à l'état de charge (SOC) est déterminé en fonction du fait de savoir quelle valeur absolue entre celle de la première variation d'état de charge ($\Delta SOC_1$) et celle de la seconde variation d'état de charge ($\Delta SOC_2$) est la plus grande.

6. Procédé selon l'une quelconque des revendications précédentes,
**caractérisé en ce que**
pour la détermination du paramètre de stratification d'acide lié à l'état de charge (SOC) dans le cas d'une décharge nette dans l'intervalle de temps entre le premier instant de fonctionnement ($t_A$) et le second instant de fonctionnement ($t_B$), on surpondère la seconde valeur d'état de charge ($SOC_2$) liée au débit de courant de la batterie d'accumulateur et déterminée au second instant de fonctionnement ($t_B$), lorsque la première variation d'état de charge ($\Delta SOC_1$) est quantitativement plus petite qu'une seconde variation d'état de charge ($\Delta SOC_2$) liée au débit de courant.

7. Procédé selon l'une quelconque des revendications précédentes,
**caractérisé en ce que**
pour la détermination du paramètre de stratification d'acide lié à l'état de charge (SOC) dans le cas d'une charge nette dans l'intervalle de temps entre le premier instant de fonctionnement ($t_A$) et le second instant de fonctionnement ($t_B$), on surpondère la première valeur d'état de charge ($SOC_1$) liée à la tension de la batterie d'accumulateur et déterminée au second instant de fonctionnement ($t_B$), lorsque la première variation d'état de charge ($\Delta SOC_1$) est quantitativement plus petite qu'une seconde variation d'état de charge ($\Delta SOC_2$) liée au débit de courant.

8. Procédé selon la revendication 7,
**caractérisé en ce qu'**
on suppose une stratification d'acide lorsque, dans le cas d'une décharge nette, la première variation d'état de charge ($\Delta SOC_1$) est plus grande que la seconde variation d'état de charge ($\Delta SOC_2$).

9. Procédé selon l'une des revendications précédentes,
**caractérisé en ce qu'**
on suppose une stratification d'acide lorsque, dans le cas d'une charge nette, la première variation d'état de charge ($\Delta SOC_1$) est plus petite que la seconde variation d'état de charge ($\Delta SOC_2$).

10. Procédé selon l'une des revendications 5 à 9,
**caractérisé en ce que**
pour la comparaison du rapport de grandeur entre la première variation d'état de charge ($\Delta SOC_1$) et la seconde variation d'état de charge ($\Delta SOC_2$), la différence ($\Delta\Delta SOC$) entre la première et la seconde variation d'état de charge ($\Delta SOC_1$ - $\Delta SOC_2$) est comparée à une valeur de seuil fixée.

11. Procédé selon la revendication 10,
**caractérisé en ce que**
la valeur de seuil se situe dans la gamme de 1 à 10 % de la valeur d'état de charge (SOC) maximale possible.

12. Procédé selon l'une des revendications précédentes,
**caractérisé en ce que**
pour la détermination des valeurs d'état de charge ($SOC_2$) liées au débit de charge ($\Delta Q$), on ne prend en compte que les quantités de charge ou les débits de décharge qui dépassent une valeur minimale fixée.

13. Procédé selon la revendication 12,
**caractérisé en ce que**
la valeur minimale fixée se situe dans la gamme de 1 à 10 % de la valeur d'état de charge (SOC) maximale possible.

14. Procédé selon l'une des revendications précédentes,
**caractérisé par**
la correction des valeurs d'état de charge (SOC) ou valeurs de capacité d'accumulateur (Q), déterminées ultérieurement, au moyen de la différence ($\Delta\Delta SOC$) déterminée antérieurement entre la première et la seconde variation d'état de charge ($\Delta SOC_1$ - $\Delta SOC_2$), en particulier en soustrayant de la différence ($\Delta\Delta SOC$) des valeurs d'état de charge (SOC) ultérieures, ou le produit de la différence ($\Delta\Delta SOC$) par la capacité nominale de la batterie d'accumulateur, des valeurs de capacité d'accumulateur (Q) ultérieures.

**15.** Procédé selon la revendication 14,
**caractérisé par**
la correction des valeurs d'état de charge (SOC) ou valeurs de capacité d'accumulateur (Q), déterminées ultérieurement, au moyen de la différence à chaque fois la plus grande ($\Delta\Delta SOC_{max}$) parmi plusieurs différences($\Delta\Delta SOC$).

**16.** Procédé selon la revendication 14,
**caractérisé par**
une correction des valeurs d'état de charge (SOC) ou valeurs de capacité d'accumulateur (Q), déterminées ultérieurement, au moyen d'une multitude de différences ($\Delta\Delta SOC$) entre la première et la seconde variation d'état de charge ($\Delta SOC_1 - \Delta SOC_2$), en particulier en soustrayant la somme de toutes les différences ($\Delta\Delta SOC$) déterminées, des valeurs d'état de charge (SOC) ultérieures, ou le produit de la différence ($\Delta\Delta SOC$) par la capacité nominale de la batterie d'accumulateur, des valeurs de capacité d'accumulateur (Q) ultérieures.

**17.** Procédé selon l'une des revendications précédentes,
**caractérisé par**
la détermination du paramètre de stratification d'acide lié à l'état de charge (SOC) en fonction de la première et de la seconde variation d'état de charge ($OSOC_1$, $\Delta SOC_2$) seulement dans le cas où, dans deux intervalles de temps différents ($\Delta t_1$, $\Delta t_2$), faisant intervenir chacun un premier et un second instant de fonctionnement ($t_A$, $t_B$), une décharge nette et une charge nette s'est effectuée, en notant supposant une stratification d'acide lorsque le rapport de décharge ($E = |\Delta SOC_1'| : |\Delta SOC_2'|$) entre la première et la seconde variation d'état de charge ($\Delta SOC_1'$, $\Delta SOC_2'$), dans l'intervalle de temps ($\Delta t_1$) où une décharge nette s'est effectuée, est plus grand que le rapport de charge ($VL = |\Delta SOC_1''| : |\Delta SOC_2''|$) entre la première et la seconde variation d'état de charge ($\Delta SOC_1''$, $\Delta SOC_2''$) dans l'intervalle de temps ($\Delta t_2$) où une charge nette s'est effectuée.

**18.** Procédé selon l'une quelconque des revendications précédentes,
**caractérisé en ce qu'**
aucun transfert de charge n'a eu lieu entre deux intervalles de temps différents ($\Delta t_1$, $\Delta t_2$),.

**19.** Procédé selon l'une des revendications précédentes,
**caractérisé par**
la régulation du processus de charge de la batterie d'accumulateur en fonction du paramètre de stratification d'acide déterminé, lié à l'état de charge (SOC), et/ou de la première et de la seconde variation d'état de charge ($\Delta SOC_1$, $\Delta SOC_2$).

**20.** Procédé selon l'une des revendications précédentes,
**caractérisé en ce que**
la batterie d'accumulateur est un accumulateur au plomb.

Fig. 1

13

Fig. 2

Fig. 3

Fig. 4

Fig. 5